(19) Europäisches Patentamt
European Patent Office
Office européen des brevets

(11) **EP 1 214 603 B1**

(12) **EUROPÄISCHE PATENTSCHRIFT**

(45) Veröffentlichungstag und Bekanntmachung des Hinweises auf die Patenterteilung:
**15.10.2003 Patentblatt 2003/42**

(21) Anmeldenummer: **00963941.0**

(22) Anmeldetag: **30.08.2000**

(51) Int Cl.$^7$: **G01R 19/25**

(86) Internationale Anmeldenummer:
**PCT/DE00/02962**

(87) Internationale Veröffentlichungsnummer:
**WO 01/022101 (29.03.2001 Gazette 2001/13)**

(54) **MESSVERFAHREN ZUR STROMMESSUNG MIT RAUSCHUNTERDRÜCKUNG**

CURRENT MEASURING METHOD WITH NOISE REJECTION

PROCEDE DE MESURE DE COURANT AVEC REDUCTION DU BRUIT

(84) Benannte Vertragsstaaten:
**CH DE FR LI**

(30) Priorität: **20.09.1999 DE 19944985**

(43) Veröffentlichungstag der Anmeldung:
**19.06.2002 Patentblatt 2002/25**

(73) Patentinhaber: **SIEMENS AKTIENGESELLSCHAFT**
**80333 München (DE)**

(72) Erfinder:
• **WINDSHEIMER, Klaus**
  **D-91174 Spalt (DE)**
• **LUBER, Thomas**
  **D-92256 Hahnbach (DE)**

(56) Entgegenhaltungen:
**GB-A- 2 230 920    US-A- 4 352 094**

EP 1 214 603 B1

**Beschreibung**

Die Erfindung betrifft ein Meßverfahren zur Ermittlung eines Kennwertes eines periodischen Stromsignals eines Verbrauchers, insbesondere eines Elektromotors, insbesondere zur Verwendung des Kennwerts für ein Simulationsmodell zur Überwachung und/oder Diagnose des Verbrauchers.

Als Stand der Technik sind Meßverfahren bekannt, bei denen Effektivwerte als Kennwerte eines periodischen Stromsignals gemessen werden. Dabei wird das Stromsignal zunächst in äquidistanten oder verjitterten Zeitabständen in n Abtastvorgängen mittels A/D-Wandler abgetastet und werden Abtastwerte i(t) ermittelt. Dann werden die Effektivwerte $i_{eff}$ des Stromsignals nach der gängigen Formel

$$i_{eff} = \sqrt{\frac{1}{n}\sum_{t=1}^{n} i^2(t)}$$

ermittelt.

Bei einer derartigen bekannten Effektivwertbestimmung wird der Effektivwert des Rauschsignals des periodischen Signals ebenfalls in vollem Umfang erfaßt und verfälscht den Effektivwert des Nutzsignals des periodischen Stromsignals.

Der Erfindung liegt die Aufgabe zugrunde, ein Meßverfahren zur Ermittlung eines Kennwertes eines periodischen Stromsignals anzubieten, bei dem eine Unterdrückung des Rauschsignals des periodischen Signals gegenüber dem Nutzsignal stattfindet.

Die Aufgabe wird durch die Merkmale des Patentanspruchs 1 gelöst. Vorteilhafte Verfahrensvarianten werden in den Unteransprüchen 2 - 3 beschrieben.

Das erfindungsgemäße Meßverfahren vermeidet Nachteile der bekannten Effektivwertberechnung und kann diese ersetzen. Im Gegensatz zur beschriebenen herkömmlichen Effektivwertberechnung wird beim erfindungsgemäßen Meßverfahren eine Folge von Doppelabtastvorgängen kurz aufeinanderfolgender Abtastungen durchgeführt. Die ermittelten aufeinanderfolgenden und paarweise einander zugeordneten Abtastwerte werden miteinander multipliziert, um dann wie in der herkömmlichen Effektivwertberechnung aufsummiert zu werden, wobei abschließend aus der Summe die Wurzel gezogen wird.

Dabei wird berücksichtigt, daß das Rauschsignal des aus einem Rausch- und einem Nutzsignal bestehenden periodischen Stromsignals im wesentlichen stochastischer Natur ist und damit in unregelmäßigen Abständen eine in etwa gleiche Anzahl von positiven und negativen Werten aufweist.

Beim Rauschsignal folgen oftmals positive und negative Werte in sehr kurzen Abständen aufeinander. Durch die erfindungsgemäße Doppelabtastung in kurz aufeinanderfolgenden Zeitabständen werden somit Abtastwerte für das Rauschsignal mit unterschiedlichen Vorzeichen erfaßt, so daß durch deren Muliplikation eine negatives Produkt entsteht.

Bei der Aufsummierung heben sich aufgrund unterschiedlicher Vorzeichen eine Vielzahl der ermittelten Produkte des Rauschsignals auf. Damit geht das Rauschsignal in geringerem Umfang in die Kennwertberechnung ein als dies bei der herkömmlichen Effektivwertberechnung der Fall ist.

Bei der herkömmlichen Effektivwertberechnung treten nur positive Produkte auf, da eine Quadrierung der jeweils ermittelten Abtastwerte durchgeführt wird und keine Produktbildung unmittelbar aufeinanderfolgender Abtastwerte stattfindet.

Die Abtastung des Stromsignals kann vereinfacht in im wesentlichen äquidistanten Zeitabständen erfolgen oder individuell an den Verlauf des periodischen Stromsignals angepaßt werden, wobei z.B. Abtastzeitpunkte zum Anfang und zum Ende der jeweiligen Halbwellen festgelegt werden können.

Der Zeitabstand $\Delta t$ zwischen erster und zweiter Abtastung gemäß Anspruch 1 kann variabel eingestellt und z.B. abhängig von der Frequenz des Stromsignals und dessen Oberwellen bestimmt werden. Hierzu kann über einen Detektor die Frequenz des Stromsignals (periodisch) erfaßt werden und bei einer Abnahme/Zunahme der Frequenz der Zeitabstand $\Delta t$ verkleinert/vergrößert werden.

Über eine Anpassung der Größe des Zeitfensters, also die Länge des Zeitraums zur Durchführung der Abtastvorgänge, kann der erfindungsgemäße Kennwert mit der gewünschten Häufigkeit ermittelt werden.

In einem bevorzugten Anwendungsfall werden die ermittelten Kennwerte des Stromsignals in ein EDV-gestütztes Simulationsmodell zur Abbildung des jeweiligen Verbrauchers eingegeben. Bei Eingabe in ein Motormodell zur Abbildung eines Elektromotors kann in Verbindung mit anderen Eingabedaten (z.B. Drehzahl, Drehmoment etc.) der Motorzustand abgebildet und überwacht werden.

Hierdurch kann z.B. eine Temperaturüberwachung des Motors ohne herkömmliche Instrumente wie Bimetallschalter oder Termistoren erfolgen. Ferner können ein Überlastungsschutz und eine Störungsdiagnose (z.B. bei Phasenausfällen) realisiert werden.

In ein derartiges Motorsimulationsmodell können die erfindungsgemäß ermittelten Kennwerte anstelle üblicher Effektivwerte zur Messung des Stromsignals des Motors eingegeben werden.

Gemäß einer vorteilhaften Verfahrensvariante werden regelmäßig nach aufeinanderfolgenden Zeitfenstern mit den jeweiligen Abtastvorgängen Summen von Abtastwerte $i(t)$ und $i(t + \Delta t)$ ermittelt, mit denen gemäß der Formel nach Anspruch 1 für jedes der Zeitfenster die erfindungsgemäßen Kennwerte $i_{kenn}$ z.B. zur Eingabe in das Motormodell bestimmt werden.

Bei einer Vorzeichenerfassung gemäß den Ansprüchen 5 oder 9 kann bei Feststellung eines negativen Vorzeichens detektiert werden, daß die negativen Produkte der Abtastwerte die positiven Produkte betragsmäßig in dem oder den vorliegenden Zeitfenster(n) übersteigen.

Dann kann für das vorliegende Zeitfenster der Kennwert $i_{kenn} = 0$ an das Motormodell ausgegeben werden. Dies kann wiederholt werden, bis der zu radizierende Bestandteil

$$\left[\frac{1}{n+m}\sum_{i=1}^{n+m} i(t) \times i(t + \Delta t)\right]$$

der Formel gemäß Anspruch 7 ein positives Vorzeichen aufweist.

Im darauffolgenden Zeitfenster kann auch der zwischenzeitlich gespeicherte Wert des Bestandteils gemäß Anspruch 5 weiterverwendet und in ein erweitertes Zeitfenster in die Formeln gemäß Anspruch 6 oder Anspruch 8 eingehen.

In einer vereinfachten Verfahrensvariante kann auch der Absolutwert des zu radizierenden Bestandteils gebildet und der entstehende positive Wert radiziert und als Kennwert $i_{kenn}$ bestimmt werden.

Weitere Einzelheiten der Erfindung ergeben sich aus den Ausführungsbeispielen und Erläuterungen in den zeichnungsfiguren. Es zeigen:

FIG 1     ein herkömmlich abgetastetes periodisches Stromsignal,

FIG 2     ein erfindungsgemäß abgetastetes periodisches Stromsignal sowie

FIG 3     ein erfindungsgemäß abgetastetes Rauschsignal.

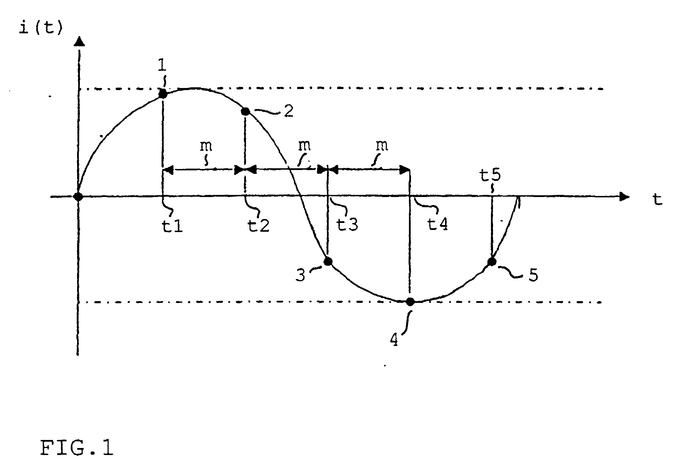

Beim herkömmlichen Meßverfahren gemäß FIG 1 wird das periodische Stromsignal zu den im wesentlichen äquidistanten Zeitabständen m zu den Zeitpunkten $t_1$, $t_2$, $t_3$, $t_4$ und $t_5$ abgetastet, so daß an den zugehörigen Abtastpunkten 1 - 5 die jeweiligen Abtastwerte $i(t)$ ermittelt werden, die gemäß der Formel

$$i_{eff} = \sqrt{\frac{1}{n}\sum_{i=1}^{n} i^2(t)}$$

zur herkömmlichen Effektivwertberechnung $i_{eff}$ verwendet werden.

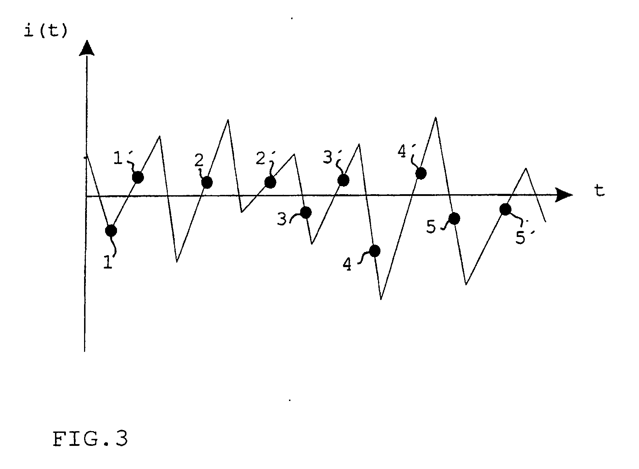

In FIG 1 ist als periodisches Stromsignal das jeweilige Nutzsignal abgebildet. Das überlagerte Rauschsignal ist nicht abgebildet und oszilliert im wesentlichen stochastisch um den Nullpunkt (vgl. FIG 3). Bei der herkömmlichen Abtastung gemäß FIG 1 werden die Abtastwerte des Rauschsignals ebenfalls zu den Zeitpunkten $t_1$ bis $t_5$ ermittelt und wie die Abtastwerte des Nutzsignals quadriert und damit verstärkt, wodurch die Effektivwertberechnung des Nutzsignals verfälscht wird.

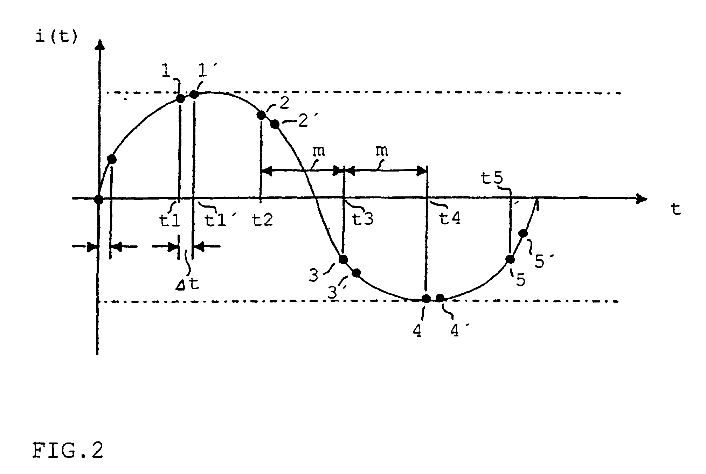

Beim erfindungsgemäßen Meßverfahren nach FIG 2 erfolgen Doppelabtastungen zu aufeinanderfolgenden Zeitpunkten $t$ und $t'= t+\Delta t$. So wird zum Zeitpunkt $t_1$ ein erster zum Abtastpunkt 1 gehöriger Abtastwert $i(t)$ und zum Abtastzeitpunkt $t_1$, ein weiterer zum Abtastpunkt 1' gehöriger Abtastwert $i(t+\Delta t)$ ermittelt. Nach n Abtastvorgängen kann der erfindungsgemäße Kennwert $i_{kenn}$ gemäß der Formel

$$i_{kenn} = \sqrt{abs\left[\frac{1}{n}\sum_{t=1}^{n} i(t) \times i(t + \Delta t)\right]}$$

nach Anspruch 1, Verfahrensschritt d) für das jeweilige Zeitfenster ermittelt werden.

Zu den Zeitpunkten $t_1$ und $t_{1'}$ wird auch das nicht abgebildete zugehörige Rauschsignal abgetastet. Aufgrund der stochastischen Natur des Rauschsignals treten häufige und kurzzeitige Vorzeichenwechsel der Abtastwerte auf, so daß regelmäßig bei aufeinanderfolgenden Abtastzeitpunkten t und t' unterschiedliche Vorzeichen der Produkte der jeweiligen Abtastwertpaare des Rauschsignals ermittelt werden.

Bei der erfindungsgemäßen Kennwertberechnung gemäß nach Anspruch 1, Verfahrensschritt d) ergeben sich Produkte aus den aufeinanderfolgenden Abtastwerten des Rauschsignals mit unterschiedlichen Vorzeichen, die bei der Aufsummierung gemäß der Formel nach Anspruch 1 sich gegenseitig aufheben oder minimieren. Damit tritt eine Verringerung des Anteils des Rauschsignals bei der Kennwertberechnung auf.

Der Zeitabstand $\Delta t$ zwischen aufeinanderfolgenden Abtastzeitpunkte eines Abtastvorgangs zu den Zeitpunkten t und t' ist in FIG 2 schematisch und stark vergrößert dargestellt. Tatsächlich ist der Zeitabstand $\Delta t$ als Bruchteil der Periodendauer des periodischen Stromsignals sowie der Periodendauer der nicht abgebildeten Oberwellen des Stromsignals auszuwählen.

Für eine bei Motorströmen häufig vorkommenden Grundfrequenz von 50 Hz mit Oberwellenfrequenzen bis zu 850 Hz kann als Zeitabstand t zwischen den aufeinanderfolgenden Abtastwerten etwa 250 µs (Abtastfrequenz von 4 kHz) verwendet werden. Eine erhebliche Fehlerverringerung und weitere Rauschunterdrückung wird erreicht, wenn statt eines Sigma-Delta-AD-Wandlers ein Sukzessive-Approximations-AD-Wandler verwendet wird, der eine maximale Abtastfrequenz von etwa 62,5 kHz besitzt, so daß ein $\Delta t$ von bis zu 16 µs erreichbar ist.

Der auftretende Fehler F(%) bei der erfindungsgemäßen Kennwertberechnung in Abhängigkeit vom Zeitabstand $\Delta t$ und von der Periodendauer T des periodischen Stromsignals im Vergleich zur herkömmlichen Effektivwertberechnung berechnet sich nach folgender Formel:

$$F[\%] = 100 \times \left[\cos\left(2\pi\frac{\Delta t}{T}\right) - 1\right] \qquad \Delta t = \left[-\frac{T}{4}; \frac{T}{4}\right]$$

FIG 3 zeigt die Abtastung eines im wesentlichen stochastisch um den Nullpunkt oszillierenden schematisch und vergrößert abgebildeten Rauschsignals als Signalanteil des periodischen Stromsignals neben dem Nutzsignal. Bei der erfindungsgemäßen Doppelabtastung werden Abtastwerte i (t) und i (t+$\Delta t$) zu den Abtastpunkten 1 und 1', 2 und 2',3 und 3',4 und 4' sowie 5 und 5' ermittelt und paarweise gemäß der Formel nach Anspruch 1, Verfahrensschritt d) miteinander multipliziert. Es entstehen Produkte mit negativem Vorzeichen bei der Multiplikation der Abtastwerte i (t) und i (t+$\Delta t$) zu den Abtastpunkten 1 und 1', 3 und 3' sowie 4 und 4' wegen der unterschiedlichen Vorzeichen der einzelnen Abtastwerte.

Durch diese Berücksichtigung der Vorzeichen der Abtastwerte des Rauschsignals erfolgt eine Rauschunterdrückung des Meßverahrens und geht das Rauschsignal in geringerem Umfang in die erfindungsgemäße Kennwertberechnung ein als bei der herkömmlichen Effektivwertberechnung.

## Patentansprüche

1. Meßverfahren zur Ermittlung eines Kennwertes eines periodischen Stromsignals eines Verbrauchers, insbesondere eines Elektromotors, insbesondere zur Verwendung des Kennwertes für ein Simulationsmodell zur Überwachung und/oder Diagnose des Verbrauchers, mit folgenden Verfahrensschritten:

   a) erste Abtastung des Stromsignals mittels eines A/D-Wandlers zu einem ersten Abtastzeitpunkt t und Ermittlung eines ersten Abtastwertes i(t);
   b) zweite Abtastung des Stromsignals mittels des A/D-Wandlers, zu einem zweiten, späteren Abtastzeitpunkt t'= t + $\Delta t$ und Ermittlung eines zweiten Abtastwertes i(t + $\Delta t$);
   c) Durchführung von n Abtastvorgängen gemäß den Verfahrensschritten a) und b),
   d) Ermittlung eines Kennwertes $i_{kenn}$ des Stromsignals nach der Formel

$$i_{kenn} = \sqrt{abs\left[\frac{1}{n}\sum_{t=1}^{n}i(t)\times i(t+\Delta t)\right]}$$

**2.** Meßverfahren nach Anspruch 1,
**dadurch gekennzeichnet, daß** die ersten Abtastungen des Stromsignals nach Verfahrensschritt a) gemäß Anspruch 1 in im wesentlichen äquidistanten Zeitabständen erfolgen.

**3.** Meßverfahren nach Anspruch 1 oder 2,
**dadurch gekennzeichnet, daß** der Zeitabstand $\Delta t$ zwischen erster und zugeordneter zweiter Abtastung nach den Verfahrensschritten a) und b) gemäß Anspruch 1 variabel einstellbar ist.

**4.** Meßverfahren nach einem der vorhergehenden Ansprüche,
**dadurch gekennzeichnet, daß** der Kennwert $i_{kenn}$ innerhalb eines variabel einstellbaren Zeitfensters ermittelt wird.

**5.** Meßverfahren nach einem der vorhergehenden Ansprüche, **dadurch gekennzeichnet, daß** das Vorzeichen des Wertes des $x_n$ genannten Bestandteils

$$\left[\frac{1}{n}\sum_{t=1}^{n}i(t)\times i(t+\Delta t)\right]$$

der Formel gemäß Anspruch 1 für $i_{kenn}$ nach Ablauf eines Zeitfensters mit n Abtastvorgängen erfaßt wird.

**6.** Meßverfahren nach Anspruch 5,
**dadurch gekennzeichnet, daß** ein negativer Wert des Bestandteils $x_n$ gemäß Anspruch 5 gespeichert und nach Ablauf eines darauffolgenden Zeitfensters mit weiteren m Abtastvorgängen $i_{kenn}$ wie folgt ermittelt wird:

$$i_{kenn} = \sqrt{abs\left[\frac{1}{m}\left\{\sum_{t=1}^{m}i(t)\times i(t+\Delta t)+x_n\right\}\right]}$$

**7.** Meßverfahren nach Anspruch 5,
**dadurch gekennzeichnet, daß** ein negativer Wert des Bestandteils $x_n$ gemäß Anspruch 5 gespeichert und nach Ablauf eines darauffolgenden Zeitfensters mit weiteren m Abtastvorgängen der folgende Bestandteil $X_{n+m}$ gebildet wird:

$$\left[\frac{1}{n+m}\sum_{t=1}^{n+m}i(t)\times i(t+\Delta t)\right]$$

**8.** Meßverfahren nach Anspruch 7,
**dadurch gekennzeichnet, daß** nach Ablauf eines ersten Zeitfensters mit n Abtastvorgängen und eines zweiten Zeitfensters mit m Abtastvorgängen $i_{kenn}$ wie folgt ermittelt wird:

$$i_{kenn} = \sqrt{abs\left[\frac{1}{n+m}\sum_{t=1}^{n+m}i(t)\times i(t+\Delta t)\right]}$$

**9.** Meßverfahren nach Anspruch 7,
**dadurch gekennzeichnet, daß** das Vorzeichen des Wertes des $x_{n+m}$ genannten Bestandteils gemäß Anspruch 7 erfaßt wird.

**Claims**

**1.** Measurement method for determining a characteristic value of a periodic current signal for a load, in particular an electric motor, in particular for the characteristic value to be used with a simulation model for monitoring and/or diagnosing the load, the method having the following steps:

a) first sample of the current signal taken using an A/D converter at a first sampling time point t, and determination of a first sampled value i(t);
b) second sample of the current signal taken using the A/D converter at a second, later, sampling time point t = t + $\Delta$t and determination of a second sampled value i(t + $\Delta$t);
c) performance of n sampling operations in accordance with the method steps a) and b);
d) determination of a characteristic value $i_{kenn}$ for the current signal in accordance with the formula

$$i_{kenn} = \sqrt{abs\left[\frac{1}{n}\sum_{t=1}^{n}i(t)\times i(t+\Delta t)\right]}$$

**2.** Measurement method in accordance with Claim 1,
**characterized by** the fact that the first samples of the current signal, made using method step a) in accordance with Claim 1, are taken at essentially equidistant intervals of time.

**3.** Measurement method in accordance with Claim 1 or 2,
**characterized by** the fact that the time interval $\Delta$t between a first and the associated second sample, made using method steps a) and b) in accordance with Claim 1, is a variable that can be set.

**4.** Measurement method in accordance with one of the preceding claims,
**characterized by** the fact that the characteristic value $i_{kenn}$ is determined within a time window which is a variable that can be set.

**5.** Measurement method in accordance with one of the preceding claims
**characterized by** the fact that the sign preceding the value of the component referred to as $x_n$, namely

$$\left[\frac{1}{n}\sum_{t=1}^{n}i(t)\times i(t+\Delta t)\right]$$

in the formula for $i_{kenn}$ according to Claim 1, is determined after a time window containing n sampling operations has expired.

**6.** Measurement method in accordance with Claim 5
**characterized by** the fact that if the value of the component xn, determined according to Claim 5, is negative this value will be saved and, when a subsequent time window containing m sampling operations has expired, $i_{kenn}$ will

be determined as follows:

$$i_{kenn} = \sqrt{abs\left[\frac{1}{m}\left\{\sum_{t=1}^{m} i(t) \times i(t + \Delta t) + x_n\right\}\right]}$$

**7.** Measurement method in accordance with Claim 5
**characterized by** the fact that if the value of the component $x_n$, determined according to Claim 5, is negative this value will be saved and, when a subsequent time window containing m sampling operations has expired, the following component $X_{n+m}$ will be formed:

$$\left[\frac{1}{n+m}\sum_{t+1}^{n+m} i(t) \times i(t + \Delta t)\right]$$

**8.** Measurement method in accordance with Claim 7,
**characterized by** the fact that, on expiry of a first time window with n sampling operations and a second time window with m sampling operations, $i_{kenn}$ is determined as follows:

$$i_{kenn} = \sqrt{abs\left[\frac{1}{n+m}\sum_{t=1}^{n+m} i(t) \times i(t + \Delta t)\right]}$$

**9.** Measurement method in accordance with Claim 7,
**characterized by** the fact that the sign preceding the component referred to as $X_{n+m}$ is determined in accordance with Claim 7.

**Revendications**

**1.** Procédé de mesure pour la détermination d'une valeur caractéristique d'un signal de courant périodique d'un consommateur, notamment d'un moteur électrique, en particulier en vue d'une utilisation de la valeur caractéristique dans un modèle de simulation pour la surveillance et/ou le diagnostic du consommateur, avec les étapes suivantes :

a) premier échantillonnage du signal de courant au moyen d'un convertisseur analogique-numérique à un premier instant d'échantillonnage t et détermination d'une première valeur échantillonnée i (t) ;
b) deuxième échantillonnage du signal de courant au moyen du convertisseur analogique-numérique à un deuxième instant d'échantillonnage postérieur t' = t + $\Delta$t et détermination d'une deuxième valeur échantillonnée i (t + $\Delta$t) ;
c) exécution de n opérations d'échantillonnage selon les étapes a) et b) du procédé ;
d) détermination d'une valeur caractéristique $i_{kenn}$ du signal de courant selon la formule

$$i_{kenn} = \sqrt{abs\left[\frac{1}{n}\sum_{t=1}^{n} i(t) \times i(t + \Delta t)\right]}$$

**2.** Procédé de mesure selon la revendication 1, **caractérisé par le fait que** les premiers échantillonnages du signal de courant selon l'étape a) du procédé selon la revendication 1 s'effectuent à des intervalles de temps sensiblement équidistants.

3. Procédé de mesure selon la revendication 1 ou 2, **caractérisé par le fait que** l'intervalle de temps $\Delta t$ entre le premier échantillonnage et le deuxième échantillonnage associé selon les étapes a) et b) du procédé selon la revendication 1 est réglable variable.

4. Procédé de mesure selon l'une des revendications précédentes, **caractérisé par le fait que** la valeur caractéristique $i_{kenn}$ est déterminée à l'intérieur d'une fenêtre temporelle réglable variable.

5. Procédé de mesure selon l'une des revendications précédentes, **caractérisé par le fait que** le signe de la valeur la partie appelée $x_n$

$$\left[ \frac{1}{n} \sum_{t=1}^{n} i(t) \times i(t + \Delta t) \right]$$

de la formule de la revendication 1 pour $i_{kenn}$ est détecté après la fin d'une fenêtre temporelle comportant n opérations d'échantillonnage.

6. Procédé de mesure selon la revendication 5, **caractérisé par le fait qu'**une valeur négative de la partie $x_n$ selon la revendication 5 est mémorisée et, après la fin d'une fenêtre temporelle suivante comportant m autres opérations d'échantillonnage; $i_{kenn}$ est déterminée de la manière suivante :

$$i_{kenn} = \sqrt{abs\left[ \frac{1}{m} \left\{ \sum_{t=1}^{m} i(t) \times i(t + \Delta t) + x_n \right\} \right]}$$

7. Procédé de mesure selon la revendication 5, **caractérisé par le fait qu'**une valeur négative de la partie $x_n$ selon la revendication 5 est mémorisée et, après la fin d'une fenêtre temporelle suivante comportant m autres opérations d'échantillonnage, la partie suivante $x_{n+m}$ est formée de la manière suivante :

$$\left[ \frac{1}{n + m} \sum_{t=1}^{n+m} i(t) \times i(t + \Delta t) \right]$$

8. Procédé de mesure selon la revendication 7, **caractérisé par le fait que**, après la fin d'une première fenêtre temporelle comportant n opérations d'échantillonnage et d'une deuxième fenêtre temporelle comportant m opérations d'échantillonnage, $i_{kenn}$ est déterminée de la manière suivante :

$$i_{kenn} = \sqrt{abs\left[ \frac{1}{n + m} \sum_{t=1}^{n+m} i(t) \times i(t + \Delta t) \right]}$$

9. Procédé de mesure selon la revendication 7, **caractérisé par le fait que** le signe de la valeur de la partie appelée $x_{n+m}$ selon la revendication 7 est détecté.

FIG.1

FIG.2

FIG.3